# EUROPÄISCHE PATENTSCHRIFT

(11) **EP 4 023 038 B1**
(45) Veröffentlichungstag und Bekanntmachung des Hinweises auf die Patenterteilung: **03.07.2024**
(21) Anmeldenummer: 20760814.2
(22) Anmeldetag: 20.08.2020
(51) Int. Cl.: H05K 7/14, H05K 5/03, H05K 5/06

(54) **GEHÄUSE FÜR EIN ELEKTRISCHES GERÄT MIT EINEM DECKEL UND ELEKTRISCHES GERÄT MIT EINEM GEHÄUSE**
HOUSING FOR AN ELECTRICAL DEVICE HAVING A COVER AND ELECTRICAL DEVICE HAVING A HOUSING
BOÎTIER POUR UN APPAREIL ÉLECTRIQUE POURVU D'UN COUVERCLE ET APPAREIL ÉLECTRIQUE POURVU D'UN BOÎTIER

(30) Priorität: 26.08.2019 DE 102019122812
(43) Veröffentlichungstag der Anmeldung: 06.07.2022
(73) Patentinhaber: SMA Solar Technology AG, 34266 Niestetal (DE)
(72) Erfinder: BREMICKER, Sven, 36211 Alheim-Baumbach (DE); DZIUBA, Martin, 34233 Fuldatal (DE); TELLO, Waissi, 34127 Kassel (DE)
(86) Internationale Anmeldenummer: PCT/EP2020/073358
(87) Internationale Veröffentlichungsnummer: WO 2021/037674

(56) Entgegenhaltungen:
- JP-A- H10 322 813
- JP-A- 2000 059 040
- JP-A- 2006 041 373
- JP-A- 2006 108 257
- JP-A- 2011 035 179
- JP-A- 2011 171 525
- JP-B2- H0 724 342
- JP-U- S6 035 584
- US-A- 3 617 610
- US-A- 4 313 025
- US-A1- 2010 149 757

## Beschreibung

### TECHNISCHES GEBIET DER ERFINDUNG

Die Erfindung betrifft ein Gehäuse für ein elektrisches Gerät zur Umwandlung einer elektrischen Leistung, sowie ein elektrisches Gerät mit einem entsprechenden Gehäuse.

Ein elektrisches Gerät im Sinne dieser Offenbarung verarbeitet elektrische Leistung, insbesondere indem elektrische Ströme von einer Form in eine andere gewandelt werden, beispielsweise von Gleichstrom in Wechselstrom oder umgekehrt, oder indem wesentliche Eigenschaften der elektrischen Leistung gezielt verändert werden, beispielsweise die Spannung oder die Frequenz. Insbesondere kann es sich um ein leistungselektronisches Gerät handeln, also einen Leistungswandler, in dem Leistungsschalter in einer Wandlertopologie angeordnet sind und mit Kapazitäten und Induktivitäten zusammenwirken.

Im Betrieb eines solchen elektrischen Geräts werden die an den Anschlüssen des Leistungswandlers anliegenden Spannungen und Ströme durch eine geeignete Taktung der Leistungsschalter gezielt beeinflusst. Dabei können erhebliche elektrische Leistungen durch das elektrische Gerät fließen und zwischen den daran angeschlossenen Einrichtungen ausgetauscht werden. Beispielsweise kann eine Energiequelle, insbesondere ein Stromversorgungsnetz, ein Generator oder eine Batterie, über einen Leistungswandler in einem erfindungsgemäßen Gehäuse mit einer Energiesenke verbunden werden, insbesondere mit einer Last, einer Batterie oder wiederum einem (weiteren) Stromversorgungsnetz.

Im Bereich der erneuerbaren Energien sind Wechselrichter zur Netzeinspeisung, beispielsweise Photovoltaik-Wechselrichter, in der Regel auf Leistungen ab etwa ein Kilowatt ausgelegt. Dies gilt auch für Batterieumrichter, die mit elektrischen Speichern verbunden sind und beispielsweise ein Inselnetz versorgen. Regelmäßig werden auch Leistungen über zehn Kilowatt in einem elektrischen Gerät mit einem Gehäuse umgewandelt. Für größere Energieerzeugungsanlagen können die Nennleistungen einzelner leistungselektronischer Geräte im Megawatt-Bereich liegen, wobei Spannungen im Kilovolt-Bereich und Ströme im Kiloampere-Bereich auftreten. Die Nennleistung ist grundsätzlich nicht nach oben begrenzt und hängt im Wesentlichen vom technischen Fortschritt hinsichtlich verfügbarer Leistungsschalter, geeigneter Topologien, erzielbarer Leistungsdichte, Werkstoffe und ähnlichem ab. Grundsätzlich steigt mit der Nennleistung eines elektrischen Geräts das Volumen des entsprechenden Gehäuses, so dass bei sehr großen Leistungen andere mechanische Konzepte verwendet werden können, insbesondere Schaltschränke statt Gehäuse.

Ein Gehäuse eines derartigen elektrischen Gerätes muss je nach Anwendungsgebiet verschiedenen normativen Anforderungen gerecht werden. Insbesondere kann das Gehäuse den Innenraum des Geräts gegenüber der Umgebung abschirmen und beispielsweise staubund wasserdicht verschließen, so dass das Gehäuse eine IP-Schutzart gemäß DIN EN 60529 aufweist und/oder einer der NEMA-Schutzarten gemäß NEMA Standard 250-2003 entspricht. Darüber hinaus muss ein Gehäuse gegebenenfalls weitere mechanische Tests gemäß DIN- und/oder UL-Normen bestehen können, beispielsweise hinsichtlich Kompression, Schlagprüfung, Fremdeinwirkung wie Vogelaufprall und/oder spezieller Wasserbestrahlung.

Das Handhaben hoher elektrischer Leistungen mit einem elektrischen Gerät bringt es mit sich, dass sich in kürzester Zeit höchste Energiekonzentrationen in dem Gehäuse des Gerätes akkumulieren können. Dies kann gewünscht sein, beispielsweise um Kapazitäten oder Induktivitäten zur Zwischenspeicherung elektrischer Energie im Rahmen der dynamischen Umwandlung von einer Stromform in eine andere zu nutzen. Es können jedoch auch unerwünschte Energiekonzentrationen auftreten, insbesondere in einem Fehlerfall, bei einer Fehlbedienung oder nach unvorhersehbaren Alterungsprozessen. Dabei kann elektrische Energie in erheblichem Umfang in thermische und/oder mechanische Energie umgewandelt werden, beispielsweise indem sich Bauteile stark erwärmen und platzen, oder indem sich entzündliche Stoffe in einem Gehäuse ansammeln, beispielsweise aufgrund (elektrochemischer Umwandlungsprozesse, und durch an sich harmlose elektrische Überschläge gezündet werden.

Daher kann sich ein erheblicher Überdruck in dem an sich verschlossenen Gehäuse des elektrischen Gerätes aufbauen. Im Falle eines leistungselektronischen Umrichters, der beispielsweise eine der üblichen Schutzklassen IP44 oder IP65 aufweist, kann sich der Überdruck zudem unter ungünstigen Umständen sehr schnell, zum Beispiel innerhalb weniger Millisekunden aufbauen. Dies darf jedoch nicht dazu führen, dass das Gehäuse in unvorhersehbarer Weise zerstört wird, zum Beispiel indem es unkontrolliert zerbricht und gegebenenfalls Teile aus dem Innenraum herausgeschleudert werden.

Sofern das Gehäuse nicht mit erheblichem Materialaufwand derart aufgebaut ist, dass es jedem erwartbaren Überdruck standhält, kann der Überdruck im Innenraum des Gehäuses durch Bereitstellen einer Entlastungsöffnung abgebaut werden. Gleichzeitig ist es jedoch zur Einhaltung der relevanten Normen notwendig, das Gehäuse so zu gestalten, dass es den Innenraum im Normalbetrieb hinreichend schützt, eine mechanische Stabilität gegen Fremdeinwirkung bietet und abgedichtet ist, gegebenenfalls wasserdicht oder sogar luft- und staubdicht.

Diese beiden Ziele - hinreichender Schutz des Innenraums und damit der darin angeordneten leistungselektronischen Komponenten gegenüber der Umgebung im Normalbetrieb einerseits und kontrollierte Bereitstellung einer ausreichend großen Entlastungsöffnung im Falle eines Überdruckes andererseits - sind funktional zunächst konträr zueinander und schränken den verfügbaren Lösungsraum erheblich ein.

### STAND DER TECHNIK

Aus dem Stand der Technik sind verschiedene Lösungen bekannt, die einen mehr oder weniger kontrollierten, möglichst gefahrlosen Druckabbau eines gegebenenfalls plötzlich auftretenden Überdrucks in einem an sich verschlossenen Gehäuse gewährleisten sollen.

Aus der DE 20 2014 100 486 U1 ist ein Gehäuse für einen Wechselrichter mit einem Deckel bekannt, bei dem der Deckel über ein deformierbares Befestigungselement am Gehäuse montiert ist, wobei das Befestigungselement bei einem plötzlich auftretenden Überdruck im Gehäuse deformiert wird und einen Spalt zwischen Deckel und Gehäuse freigibt, durch den der Überdruck abgebaut werden kann.

Aus der DE 20 2015 106 657 U1 ist ein Gehäuse zur Aufnahme elektronischer Komponenten bekannt, bei dem ein Deckel an mehreren Befestigungspunkten mit einem Gehäusekörper verbunden ist, wobei im Bereich von mindestens einem der Befestigungspunkte Aussparungen vorgesehen sind, die eine Verformung des Gehäuses im Falle eines Überdrucks im Innenraum ermöglichen, so dass der Überdruck durch einen entstehenden Spalt zwischen Gehäusekörper und Deckel abgebaut werden kann.

Aus der US 2016 249 467 A1 ist ein Druckabbaumechanismus für ein Gehäuse eines elektrischen Gerätes bekannt, bei dem eine Druckabbauöffnung im Gehäuse durch einen außenliegenden Deckel verschlossen wird, der von einer Feder nach innen gezogen wird, so dass er durch einen Überdruck nach außen gedrückt wird und die Öffnung freigibt.

Aus der EP 0 435 123 A1 ist ein Gehäuse bekannt, das eine Druckentlastungswand bestehend aus zwei spiegelsymmetrisch angeordneten und mittig aneinander stoßenden Druckentlastungsklappen aufweist, wobei die Druckentlastungsklappen mittels Befestigungsflanschen einerseits starr mit den Gehäusewänden verbunden sind und andererseits durch gezielte Schwächung der Befestigungsflansche im Falle eines Überdruckes aufschwingen können. Dabei wird darauf hingewiesen, dass ein Aufwölben der Oberflächen der Druckentlastungsklappen zu vermeiden ist, da dadurch das Aufschwingen der Druckentlastungsklappen behindert wird; sofern das Aufschwingen jedoch tatsächlich stattfindet, können Teile aus dem Innenraum ungehindert in die Umgebung gelangen.

Aus der US 2013 143 478 A1 ist ein Gehäuse für ein elektrisches Gerät bekannt, bei dem eine Druckentlastungsöffnung vorgesehen ist, die aus vier dreieckigen Klappen besteht, deren Schenkel zusammenstoßen und deren Grundseiten ein Quadrat bilden, wobei die Klappen jeweils nur an ihrer Grundseite mit dem Gehäuse verbunden sind und entlang ihrer Grundseite gezielte Schwachstellen aufweisen, so dass alle Klappen im Falle eines Überdrucks im Gehäuse nach außen aufgebogen werden und eine Druckentlastungsöffnung freigeben.

Aus der US 2010/149757 A1 ist ein Gehäuse für ein elektrisches Gerät mit einem Grundkörper und einem Deckel bekannt, bei dem ein Innenraum gebildet wird, der gasdicht abgeschlossen sein soll. Das bevorzugte Mittel zur Abdichtung des Deckels gegenüber dem Gehäuse ist eine stabile, zum Beispiel geklammerte, geklebte oder geschweißte Verbindung zwischen dem Deckel und dem Rand des Grundkörpers. Ein zusätzliches Befestigungsmittel, das in der Mitte des Deckels angebracht sein kann, dient dabei dem Zweck, eine Verformung des Gehäuses im Falle eines etwaigen Überdrucks im Innenraum zu verhindern.

Aus der US 4 313 025 A ist ein Gehäuse für ein elektrisches Gerät mit einem Grundkörper und einem Deckel bekannt, bei dem ein Innenraum gebildet wird, der eine mikrofonisch und akustisch gedämpfte Kavität bildet. Dazu wird ein Deckel verwendet, der bevorzugt aus einem akustisch dämpfenden, d.h. aus einem starren, aber flexiblen Material mit einem hohen Biegemodul besteht, z.B. einem martensitischen Stahl.

Aus der JP S60 35584 U und der JP 2011 035179 A sind weitere Ausführungsformen eines Gehäuses für ein elektrisches Gerät mit einem Grundkörper und einem Deckel bekannt, bei denen der Deckel mittels eines Befestigungsmittels in der Mitte des Deckels am Grundkörper befestigt ist.

Keine der bekannten Lösungen stellt im Falle eines plötzlich auftretenden Überdrucks im Innenraum des Gehäuses eine ausreichend große Öffnung zum Druckabbau hinreichend schnell zur Verfügung und erfüllt gleichzeitig die eingangs genannten Anforderungen an die mechanischen Eigenschaften eines Gehäuses, das insbesondere für ein elektrisches Gerät zur Umwandlung erheblicher elektrischer Leistungen geeignet sein soll.

### AUFGABE DER ERFINDUNG

Der Erfindung liegt daher die Aufgabe zugrunde, ein Gehäuse für ein elektrisches Gerät bereitzustellen, das den üblichen Umgebungs- und Einsatzbedingungen eines solchen Geräts standhält und zugleich eine große Druckentlastungsfläche in so kurzer Zeit zu Verfügung stellen kann, dass ein plötzlich entstehender Überdruck kontrolliert abgebaut werden kann, wobei die im Innenraum des Gehäuses angeordneten Teile zurückgehalten werden und somit die Sicherheit erhöht wird.

### LÖSUNG

Die Aufgabe wird durch eine Vorrichtung mit den Merkmalen des unabhängigen Patentanspruchs 1 gelöst. Bevorzugte Ausführungsformen sind in den abhängigen Patentansprüchen definiert.

### BESCHREIBUNG DER ERFINDUNG

Ein Gehäuse eines elektrischen Geräts zur Umwandlung einer elektrischen Leistung weist einen Grundkörper und einen Deckel auf. Der Deckel verschließt den Grundkörper, so dass ein abgeschlossener Innenraum entsteht: Im Innenraum des Gehäuses sind elektrische und elektronische Komponenten des elektrischen Geräts angeordnet. Der Deckel ist über ein lösbares Befestigungsmittel mit dem Grundkörper verbunden ist. Das Gehäuse ist dadurch gekennzeichnet, dass das Befestigungsmittel in der geometrischen Mitte des Deckels angeordnet ist.

Die der Erfindung zugrundeliegende Aufgabe wird somit dadurch gelöst, dass das elektrische Gerät ein geschlossenes Gehäuse als Schutzvorrichtung aufweist, wobei der lösbar befestigte Deckel des Gehäuses als Umgebungsschutz mit integrierter Überdrucksicherung ausgestaltet ist. Bei einem plötzlich entstehenden Überdruck dient die gesamte Fläche um das zentrale Befestigungsmittel herum als Angriffsfläche für Druckspitzen und Impulse. Der Deckel wird lediglich durch seine Steifigkeit dabei behindert, sich zu verformen. Dadurch wirkt der Deckel als Überdrucksicherung und ermöglicht einen ausreichenden Druckabbau.

Zugleich wird der Deckel durch das zentrale Befestigungsmittel am Grundkörper festgehalten. Das Befestigungsmittel ist in der Mitte des Deckels angeordnet, so dass es im Mittel gleich weit von allen Rändern des Deckels entfernt ist. Dabei sind gewisse Abweichungen von einem geometrisch exaktem Mittelpunkt selbstverständlich möglich sind, beispielsweise aus konstruktiven oder rein optischen Gründen. Die dem Innendruck ausgesetzte Fläche des Deckels entspricht dadurch im Wesentlichen einem Kreisring im Falle eines runden Deckels oder einem "quadrierten Kreisring" im Falle eines quadratischen Deckels. Dieser Kreisring hält weiterhin etwaige im Inneren des elektrischen Geräts abgelöste Teile zurück oder lenkt diese zumindest seitlich ab, sofern er sich verformt und dadurch (teilweise) geöffnet hat. Insofern schützt der Deckel die Umgebung des elektrischen Geräts gegen eine Druckwelle und minimiert die Gefährdung von Personen.

Der Deckel ist insbesondere ausschließlich durch das mittig angeordnete Befestigungsmittel am Grundkörper befestigt und durch keine weiteren Befestigungsmittel mit dem Grundkörper verbunden. Es versteht sich dabei, dass vergleichsweise schwache Verbindungen zwischen Deckel und Gehäuse, beispielsweise Adhäsionskräfte von Dichtungen, leichte Verkantungen oder Führungshaken nicht als Befestigungsmittel zu verstehen sind.

In einer Ausführungsform des Gehäuses weist der Grundkörper eine Rückwand und Seitenwände auf, und der Deckel weist eine im Wesentlichen in einer Ebene verlaufende Dichtungsfläche auf. Der Deckel liegt dann mit der Dichtungsfläche auf Kanten der Seitenwände des Deckels. Es versteht sich, dass die Seitenwände durch ein einziges Bauteil gebildet werden können; insofern sind auch Gehäuse mit runder Rückwand und entsprechend durchgängiger Seitenwand umfasst.

Zwischen den Kanten der Seitenwände des Grundkörpers und dem Deckel kann eine umlaufende Dichtung angeordnet sein. Auf die Dichtung wird durch das Befestigungsmittel über den Deckel eine Druckkraft ausgeübt. Diese Druckkraft ist abhängig von der Steifigkeit des Deckels und kann so eingestellt werden, dass das Gehäuse dicht verschließbar ist. Dadurch kann eine Schutzart des Innenraums des Gehäuses von mindestens IP45, bevorzugt von mindestens IP65 und/oder Nema Type 4X gewährleistet werden.

Der gesamte Deckelaufbau mit zentral angebrachtem Befestigungsmittel und umlaufender Dichtung wird so ausgelegt, dass das elektrische Gerät unter allen Witterungsbedingungen und bei allen elektrischen Parametern dauerhaft und sicher betreibbar ist. Dazu ist insbesondere die Deckelsteifigkeit so bemessen, dass der Deckel einerseits steif genug ist, um eine Anpresskraft vom zentralen Befestigungsmittel über die Deckelfläche derart auf den Rand und damit auf die Dichtung zu übertragen, dass die Dichtung die notwendige Kompressionskraft erfährt. Gleichzeitig verfügt der Deckel über eine derart optimierte Steifigkeit, dass er sich umlaufend zum zentral angebrachten Befestigungsmittel bei Erreichen eines bestimmten Innendruckes verformen kann. Dadurch kann eine optimierte Öffnungsfläche zur Druckentlastung erzeugt werden und der Druck entweicht langsam. Zudem wird die Belastung des Befestigungsmittels und einer dieses umfassenden Haltevorrichtung insgesamt bei einer Explosion vermindert, indem der Deckel sich verformt und die wirksame Angriffsfläche für den Innendruck vermindert, so dass der Deckel nicht am Befestigungsmittel ausreißt.

Die Haltevorrichtung kann eine Traverse umfassen, die an gegenüberliegenden Punkten der Seitenwände des Grundkörpers befestigt ist. Diese Traverse dient als Gegenstück zum außen angeordneten und lösbaren Befestigungsmittel, so dass mittels des Befestigungsmittels eine lösbare Verbindung zwischen dem Deckel und der Traverse herstellbar ist.

Das Gehäuse kann vier Seitenwände aufweisen, die im Wesentlichen senkrecht zu einer Rückwand des Gehäuses angeordnet sind. Die Traverse kann dann vorteilhaft diagonal zwischen zwei gegenüberliegenden Ecken der Seitenwände angeordnet sein. An den Ecken der Seitenwände ist das Gehäuse besonders steif, so dass die Anbindung der Traverse über die Ecken des Gehäuses die Traglast der Haltevorrichtung erhöht. Zudem sind durch eine diagonale Anordnung der Traverse zwei Ecken des Gehäuses frei zugänglich, wobei eine dieser Gehäuseecken insbesondere einen Anschlussbereich des elektrischen Gerätes umfassen kann. Dieser Anschlussbereich ist dann bei geöffnetem Deckel weitgehend frei zugänglich, so dass die Traverse bei einer Inbetriebnahme des Gerätes im Gerät verbleiben kann und kein zusätzlicher Montageaufwand anfällt.

Alternativ oder zusätzlich zur Traverse kann der Grundkörper einen Dom aufweisen, der sich von der Rückwand des Gehäuses bis zur geometrischen Mitte des Deckels erstreckt. Dieser Dom kann auf der dem Deckel zugewandten Seite ein Gegenstück zum Befestigungsmittel aufweisen, so dass mittels des Befestigungsmittels eine lösbare Verbindung zwischen dem Deckel und dem Dom herstellbar ist. Ein derart zentral angeordneter Dom mit Befestigung an der Rückseite des Grundkörpers bietet eine optimale Zugänglichkeit des Innenraums des Gehäuse bei geöffnetem Deckel.

Das Befestigungsmittel kann insbesondere schraubbar ausgeführt sein und eine Schraube oder eine Mutter umfassen. Dabei ist der Schraubenkopf beziehungsweise die Mutter auf der Außenseite des Deckels angeordnet. Ein Gegengewinde für die Schraube beziehungsweise eine nach außen gerichtete Gewindestange für die Mutter kann an der Traverse beziehungsweise am Dom angeordnet sein. Insbesondere kann der Dom selbst eine Stange oder ein Rohr umfassen, die/das sich von der Rückwand durch den Innenraum und durch den Deckel erstreckt, so dass das Befestigungsmittel direkt auf die Stange beziehungsweise in das Rohr geschraubt werden kann.

In einer weiteren Ausführungsform kann zwischen dem Schraubenkopf beziehungsweise der Mutter und dem Deckel eine Versteifungsplatte (17) angeordnet sein, die bevorzugt kraft- und/oder stoffschlüssig mit dem Deckel verbunden ist. Die Versteifungsplatte weist insbesondere einen Durchmesser zwischen dem doppelten Durchmesser des Schraubenkopfes beziehungsweise der Mutter und dem halben Durchmesser des Deckels auf. Dadurch wird verhindert, dass eine von innen auf den Deckel wirkende Kraft aufgrund eines Überdrucks lediglich auf das Befestigungsmittel selbst wirkt und der Deckel um das Befestigungsmittel herum ausreißt.

Das erfindungsgemäße Gehäuse kann im Innenraum besonders vorteilhaft leistungselektronische Komponenten beherbergen. Dazu gehören insbesondere Schalter, Kapazitäten und/oder Induktivitäten, die für die Umwandlung der elektrischen Leistung innerhalb des Gerätes vorgesehen sind.

Im Falle eines im Innenraum des Gehäuses auftretenden Überdrucks, insbesondere im Falle eines plötzlich auftretenden Überdrucks, wie er bei einem elektrischen Gerät mit hoher Leistung auftreten kann, kann der Deckel allseitig, insbesondere entlang der umlaufenden Dichtung, von den Kanten der Seitenwände abheben und sich plastisch verformen. Dadurch ist ein Druckabbau nach allen Seiten möglich. Die plastische Verformung führt zudem zu einer Entlastung des Befestigungsmittels und der damit korrespondierenden Haltevorrichtung, da die Fläche, auf die der Überdruck wirkt, durch die Verformung des Deckels abnimmt. Dadurch nimmt auch die Zugkraft auf das Befestigungsmittel ab.

Der Deckel kann bevorzugt aus einem duktilen Werkstoff bestehen oder einen solchen Werkstoff enthalten, der sich unter Belastung dauerhaft plastisch verformen kann. Insbesondere Aluminium-Magnesium-Legierungen, zum Beispiel AIMg3, oder Tiefziehstahlblech weisen ein geeignetes Verhältnis zwischen Zugfestigkeit und Streckgrenze auf. Die bei einer Explosion freiwerdende Energie der Druckwelle wird durch eine plastische Verformung des Deckels aufgezehrt. Besonders vorteilhaft weist der Werkstoff eine Bruchdehnung von >6% auf, insbesondere um ein Ausreißens des Deckels am Befestigungsmittel zu vermeiden.

In einer weiteren Ausführungsform weist der Rand des Deckels eine umlaufende Abkantung auf, so dass der Rand des Deckels im Wesentlichen parallel zu den Seitenwänden des Grundkörpers ausgerichtet ist. Dadurch kann der Deckel besonders einfach passgenau auf dem Grundkörper montiert werden, und eine etwaige Dichtung wird durch die Abkantung seitlich geschützt und/oder abgestützt, das heißt gegebenenfalls an einer Querkontraktion gehindert.

In einer besonders bevorzugten Ausführungsform umfasst das elektrische Gerät einen Leistungswandler, insbesondere einen Gleichrichter, einen Wechselrichter und/oder einen DC/DC-Wandler. Der Leistungswandler kann eine elektrische Nennleistung von mindestens ein Kilowatt, bevorzugt von mindestens zehn Kilowatt aufweisen. Gerade im Bereich der Leistungswandler mit Nennleistungen im Bereich einige zehn bis einige hundert Kilowatt bringt der technische Fortschritt Steigerungen der Leistungsdichte mit sich, die gleichzeitig das eingangs erläuterte Problem der unerwünschten Energieakkumulationen verschärfen und daher an das entsprechend steigende Risiko angepasste Gehäuse benötigen.

Ein erfindungsgemäßes elektrisches Gerät weist ein Gehäuse mit den beschriebenen Eigenschaften auf und umfasst einen ersten Anschluss und einen zweiten Anschluss zum Austausch elektrischer Leistung mit separaten Einrichtungen. Dabei kann der erste Anschluss zur Verbindung mit einer ersten Energiequelle oder einer ersten Energiesenke, insbesondere mit einem Generator oder einer Batterie, und der zweite Anschluss zur Verbindung mit einer zweiten Energiequelle oder einer zweiten Energiesenke, insbesondere mit einem Energieversorgungsnetzwerk, eingerichtet sein.

In einer Ausführungsform ist das Gerät ein Photovoltaik-Wechselrichter oder ein bidirektionaler Batterie-Wechselrichter zum Anschluss an ein Wechselspannungsnetz.

In einer weiteren Ausführungsform ist das Gerät ein DC/DC-Wandler zur Verbindung eines Photovoltaik-Generators oder einer Batterie mit einem Wechselrichter oder einer Last, wobei die Last ein Gleichspannungsnetz umfassen kann.

Insbesondere ein Energieversorgungsnetz und/oder eine Batterie sind besonders potente Energielieferanten, die besonders hohe Energieakkumulationen ermöglichen, so dass das Gehäuse des Geräts entsprechend ausgelegt sein muss. Dies gilt insbesondere für elektrische Geräte mit einer Nennleistung von mindestens ein Kilowatt und erst recht für elektrische Geräte mit einer Nennleistung von mindestens zehn Kilowatt.

### KURZBESCHREIBUNG DER FIGUREN

Im Folgenden wird die Erfindung anhand in den Figuren dargestellter Ausführungsbeispiele weiter erläutert und beschrieben.
- Fig. 1: zeigt eine erste Ausführungsform einer erfindungsgemäßen Vorrichtung;
- Fig. 2: zeigt eine Schnittdarstellung einer weiteren Ausführungsform der erfindungsgemäßen Vorrichtung;
- Fig. 3: zeigt eine Schnittdarstellung einer weiteren Ausführungsform der erfindungsgemäßen Vorrichtung;
- Fig. 4: zeigt eine weitere Ausführungsform der erfindungsgemäßen Vorrichtung,
- Fig. 5: zeigt eine weitere Ausführungsform der erfindungsgemäßen Vorrichtung, und
- Fig. 6: zeigt das dynamische Verhalten einer erfindungsgemäßen Vorrichtung.

### FIGURENBESCHREIBUNG

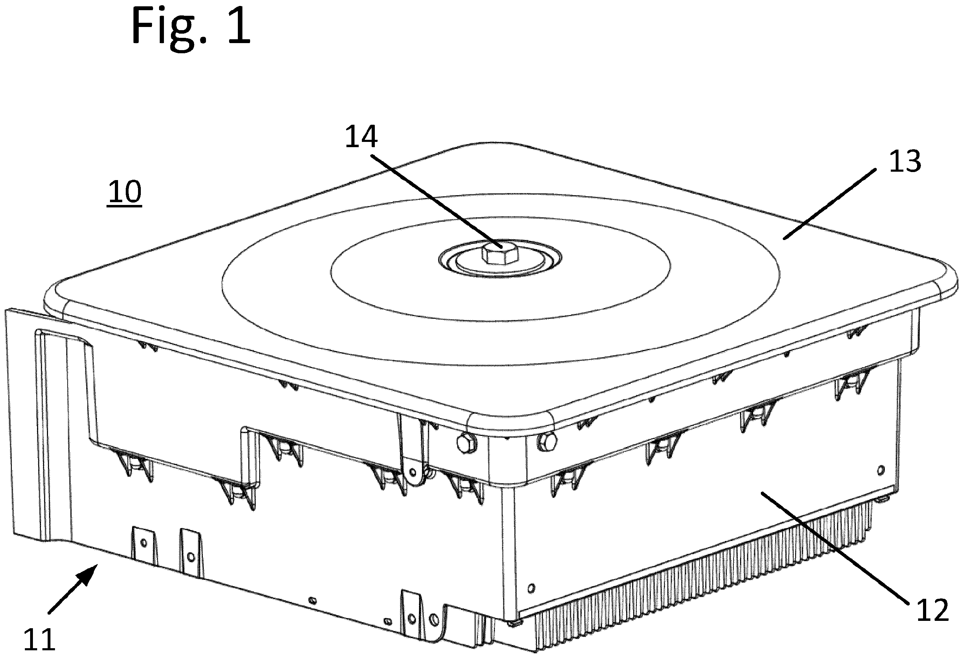

**Fig. 1** zeigt ein elektrisches Gerät 10 mit einem Gehäuse 11. Das Gehäuse 11 umfasst einen Grundkörper 12. Der Grundkörper 12 kann einteilig ausgebildet sein, beispielsweise als Druckguss-Formteil, oder aus mehreren Teilen bestehen, insbesondere aus einer Rückwand und Seitenwänden. Grundsätzlich kann der Grundkörper einen im wesentlichen rechteckigen Grundriss gemäß Fig. 1 aufweisen, so dass er vier im Wesentlichen ebene Seitenwände umfasst, oder einen runden oder ovalen Grundriss aufweisen (nicht dargestellt), so dass er im Wesentlichen eine umlaufende Seitenwand aufweist.

Das Gehäuse 11 umfasst einen Deckel 13. Der Grundkörper 12 und der Deckel 13 bilden einen abgeschlossenen Innenraum des Gehäuses 11 aus, indem der Deckel 13 kraftschlüssig auf die Kanten der Seitenwände des Grundkörper 12 aufgelegt wird. Etwaige Öffnungen in den Seitenwänden und/oder der Rückwand des Grundkörpers 12, beispielsweise für Kabeldurchführungen, können dabei selbst mit geeigneten Abdichtungen ausgeführt werden.

Der Deckel 13 ist über ein zentrales Befestigungsmittel 14 lösbar mit dem Grundkörper 12 verbunden. Das Befestigungsmittel 14 kann gemäß Fig. 1 als Schraube ausgeführt sein, deren Schraubenkopf auf der Außenseite des Deckels 13 angeordnet ist und die in ein Gewinde eingeschraubt ist, das im Innenraum des Gehäuses 11 angeordnet ist. Alternativ sind weitere Ausführungen des lösbaren Befestigungsmittels 14 denkbar, beispielsweise als Mutter auf einer aus der Außenseite des Deckels 13 herausragenden Gewindestange, als Steckverbindung mit Arretierung oder ähnliches. Das Befestigungsmittel 14 ist jedoch das einzige Befestigungsmittel, mit dem eine definierte, dauerhaft stabile und lösbare Verbindung zwischen Grundköper 12 und Deckel 13 hergestellt wird.

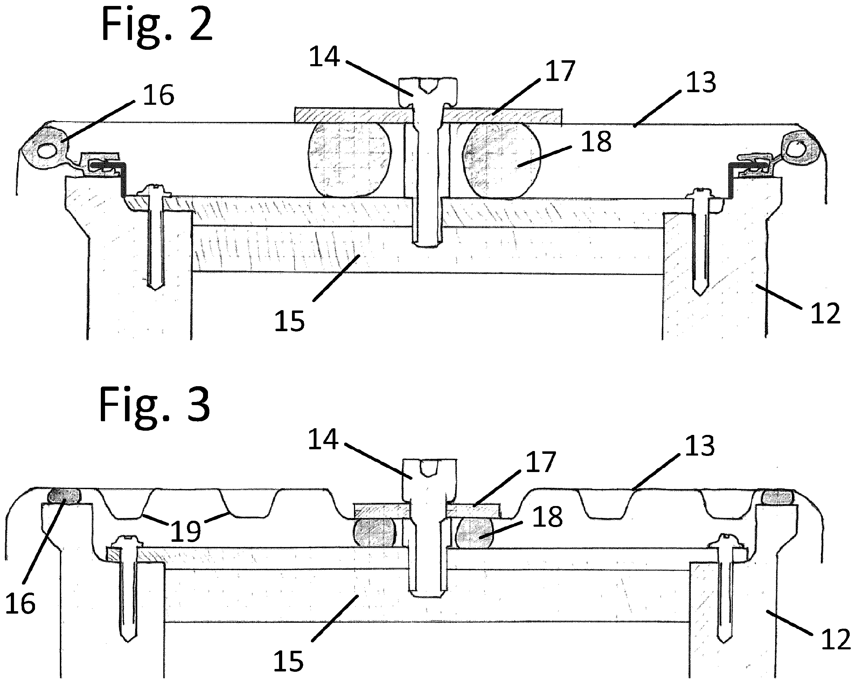

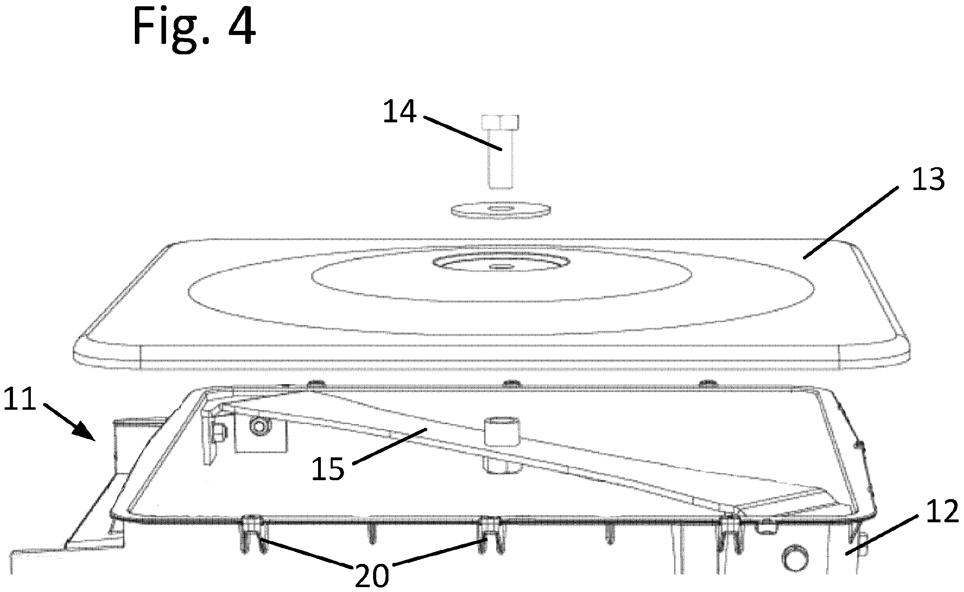

**Fig. 2** zeigt einen Querschnitt durch ein Gehäuse 11 mit Teilen des Grundkörpers 12, insbesondere den Randgebieten der Seitenwände, und einem Deckel 13. Zwischen den Seitenwänden des Grundkörpers 12 ist eine Traverse 15 angeordnet. Das Befestigungsmittel 14 stellt eine lösbare Verbindung zwischen dem Deckel 13 und der Traverse 15 und damit zum Grundkörper 12 her. Die Traverse 15 kann gemäß Fig. 2 auf einer Kante der Seitenwand des Grundkörpers 12 aufliegen und dort befestigt sein oder in anderer Form mit den Seitenwänden des Grundkörpers 12 verbunden sein, gegebenenfalls auch lösbar (vergl. Fig. 4).

Die vom Befestigungsmittel 14 auf den Deckel 13 ausgeübte Kraft wird über die Fläche des Deckels 13 auf die Ränder des Deckels 13 übertragen. Dadurch kann eine zwischen dem Deckel 13 und den Rändern der Seitenwände des Grundkörpers 12 angeordnete Dichtung 16 komprimiert werden und dem Übergang zwischen Grundkörper 12 und Deckel 13 abdichten. Die resultierende Kraft, die auf die Dichtung 16 wirkt, kann je nach Auslegung und Anwendungsbereich des Gerätes 10 so gewählt werden, dass die jeweils geforderte Dichtheit des Gehäuses 11 erreicht wird. Dabei hängt die resultierende Kraft auf die Dichtung 16 unter anderem von den konkreten Materialeigenschaften des Deckels ab, insbesondere dessen Steifigkeit, sowie von konstruktiv gegebenen Begrenzungen des Befestigungsmittels, beispielsweise einer Gewindelänge der Schraube beziehungsweise eines vergleichbaren Gewindestabes. Dabei sind die Materialeigenschaften des Deckels 13, insbesondere dessen Steifigkeit, so auszulegen, dass die notwendige Kompressionskraft auf die Dichtung 16 erreicht wird.

Die Dichtung 16 kann gemäß Fig. 2 als Hohlkammerdichtung ausgeführt werden, die bereits bei kleinen resultierenden Kräften eine gute Dichtwirkung zwischen Grundkörper 12 und Deckel 13 erzielt. Damit kann erreicht werden, dass das Gehäuse 11 insgesamt eine Schutzart von IP45 oder höher aufweist.

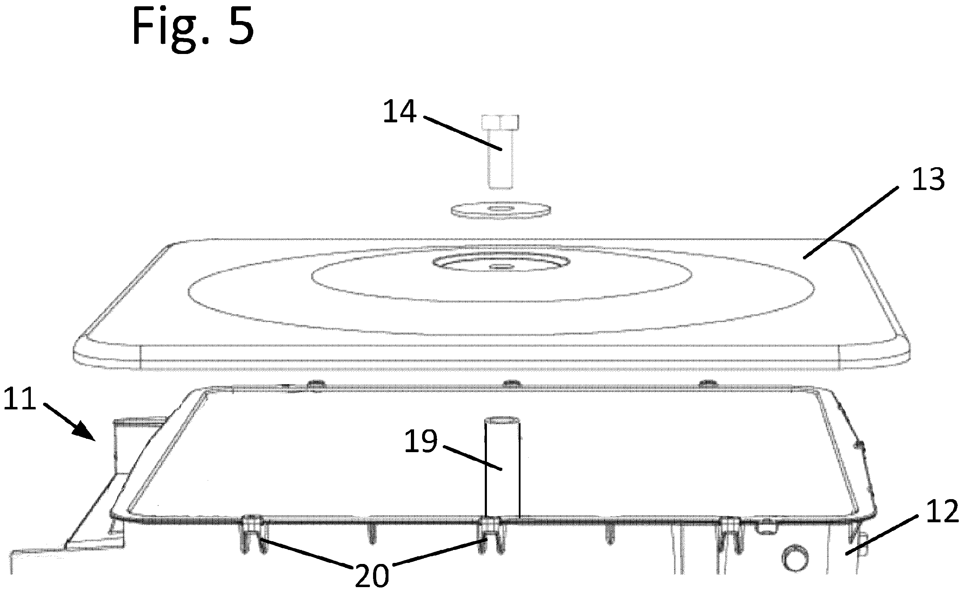

Zwischen dem äußeren Angriffspunkt des Befestigungsmittels 14, gemäß Fig. 1 also dem Schraubenkopf, und dem Deckel 13 kann eine Versteifungsplatte 17 angeordnet sein, beispielsweise eine Unterlegscheibe, die eine runde oder eckige Form aufweisen kann. Zwischen dem Deckel 13 und der Traverse 15 können weitere Abstandselemente 18 angeordnet sein, beispielsweise Dichtringe oder massive Anschraubblöcke, die einen definierten Abstand zwischen Deckel 13 und Traverse 15 im Bereich der Versteifungsplatte 17 vorgeben können. Alternativ zur Traverse 15 ist ein Dom 19 verwendbar (vergleiche Figur 5).

Der Deckel 13 gemäß Fig. 2 weist eine im Wesentlichen ebene Form mit einer umlaufenden Abkantung auf und kann aus einem einfachen Blech bestehen, dass insbesondere mittels eines Tiefziehverfahrens in die geeignete Form gebracht wurde.

**Fig. 3** zeigt einen Querschnitt durch ein weiteres erfindungsgemäßes Gehäuse 11. Im Unterschied zur Ausführungsform gemäß Fig. 2 ist die Dichtung 16 hier aus Vollmaterial ausgeführt oder aus einem geschäumten Kunststoff. Eine solche Dichtung ist einfacher zu verarbeiten und insgesamt kompakter als eine Hohlkammerdichtung gemäß Fig. 2. Zusätzlich sind am Deckel 13 gemäß Fig. 3 Versteifungsstreben 19 angeordnet, die die Steifigkeit des Deckels 13 erhöhen und daher eine bessere Übertragung der vom Befestigungsmittel 14 auf den Deckel 13 ausgeübten Kraft über die Fläche des Deckels 13 auf die Ränder des Deckels 13 und damit auf die Dichtung 16 ausgeübte Kraft gewährleisten.

**Fig. 4** zeigt eine Darstellung eines erfindungsgemäßen Gehäuses 11 mit einem Grundkörper 12 und einem geöffneten Deckel 13. Der Deckel 13 kann mittels eines Befestigungsmittels 14 lösbar mit der Traverse 15 verbunden werden. Eine vom Befestigungsmittel 14 auf den Deckel 13 ausgeübte Kraft wird über die Fläche des Deckels 13 auf die Ränder des Deckels 13 übertragen und komprimiert dort eine Dichtung, die zwischen dem Deckel und den Rändern der Seitenwände des Grundkörpers 12 angeordnet ist (nicht dargestellt). Dabei weist der Deckel 13 eine leicht konvexe Form auf, das heißt er ist vom Innenraum des Gehäuses 11 aus gesehen nach außen aufgewölbt. Dadurch wird eine bessere Übertragung der Kraft vom Befestigungsmittel 14 auf die Dichtung erzielt.

Die Traverse 15 kann gemäß Fig. 4 diagonal zwischen den oberen Ecken des Grundkörpers 12 angeordnet und mit den Seitenwänden des Grundkörpers 12 verbunden sein. Alternativ kann die Traverse 15 zwischen beliebigen, gegenüberliegenden Punkten der Seitenwände aufgespannt werden, das heißt zwischen Punkten, deren Verbindungsgerade durch die geometrische Mitte der Öffnung des Grundkörpers 12 verläuft, so dass das Befestigungsmittel 14 in der geometrischen Mitte des Deckels 13 angeordnet ist.

Die Traverse 15 kann lösbar mit den Seitenwänden des Grundkörpers 12 verbunden sein oder fest an diesen angebracht sein. Der Grundkörper 12 kann weitere Randelemente 20 umfassen, beispielsweise Führungshilfen zur korrekten Positionierung des Deckels 13 auf dem Grundkörper 12 oder Kontaktstifte zur Herstellung eines Potentialausgleichs zwischen Grundkörper 12 und Deckel 13. Auch hier sind jedoch neben dem Befestigungsmittel 14 keine weiteren definierten, dauerhaft stabilen und lösbaren Verbindungen zwischen Grundköper 12 und Deckel 13 vorgesehen.

**Fig. 5** zeigt eine weitere Darstellung eines erfindungsgemäßen Gehäuses 11 mit einem Grundkörper 12 und einem geöffneten Deckel 13. Der Grundkörper weist einen zentral angeordneten Dom 19 auf, der an der Rückseite des Grundkörpers 11 befestigt sein kann und sich bis unter oder sogar durch die die geometrische Mitte des Deckels 14 erstreckt. Der Deckel 13 kann mittels eines Befestigungsmittels 14 lösbar mit dem Dom 19 verbunden werden. Konkret kann der Dom 19 ein Gegengewinde aufweisen, in das das Befestigungsmittel 14, hier beispielsweise eine Schraube, eingeschraubt wird. Alternativ kann der Dom 19 über den Deckel 19 hinausragen, so dass ein Befestigungsmittel 14, hier beispielsweise eine Mutter, auf den Dom 19 aufgeschraubt werden kann.

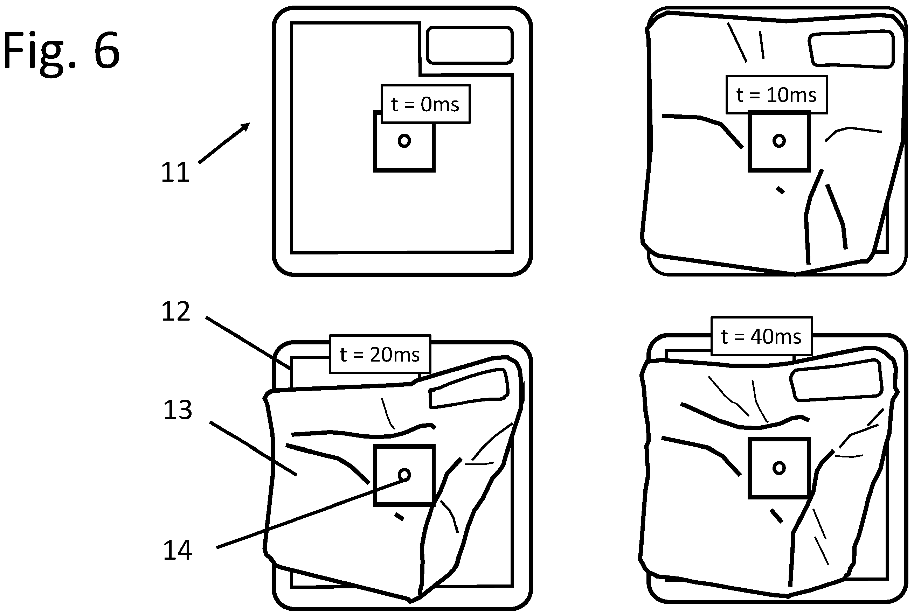

**Fig. 6** zeigt eine Simulation der plastischen Verformung des Deckels 13 im Falle eines explosionsartigen Überdrucks im Innenraum des elektrischen Geräts 10. Zum Zeitpunkt t=0ms erfolgt der explosionsartige Druckaufbau (links oben). Der Deckel 13 liegt zu diesem Zeitpunkt auf den Kanten der Seitenränder des Grundkörpers 11 auf und schützt den Innenraum des Gehäuses 11 vor Umgebungseinflüssen. Zum Zeitpunkt t=10ms (rechts oben) wird der Deckel 13 aufgrund eines Überdrucks im Inneren verformt und hebt allseitig von den Kanten der Seitenränder 12 ab. Diese Verformung setzt sich bis zum Zeitpunkt t=20ms geringfügig fort und kommt sodann zu Stillstand, nachdem der Überdruck im Innenraum abgebaut ist. Der Deckel 13 befindet sich dann zum Zeitpunkt t=40ms in einer Endposition (rechts unten).

### BEZUGSZEICHENLISTE

- 10: Elektrisches Gerät
- 11: Gehäuse
- 12: Grundkörper
- 13: Deckel
- 14: Befestigungsmittel
- 15: Traverse
- 16: Dichtung
- 17: Versteifungsplatte
- 18: Dichtung
- 19: Dom
- 20: Randelement

## Patentansprüche

1. Gehäuse (11) eines elektrischen Geräts (10) zur Umwandlung elektrischer Leistung, wobei das Gehäuse (11) einen Grundkörper (12) und einen Deckel (13) aufweist, wobei der Deckel (13) den Grundkörper (12) verschließt, so dass ein abgeschlossener Innenraum entsteht, wobei im Innenraum des Gehäuses (11) elektrische und elektronische Komponenten des elektrischen Geräts (10) angeordnet sind, wobei der Deckel (13) über ein lösbares Befestigungsmittel (14) mit dem Grundkörper (12) verbunden ist, wobei das Befestigungsmittel (14) in der geometrischen Mitte des Deckels (13) angeordnet ist, **dadurch gekennzeichnet, dass**
der Deckel (13) ausschließlich durch das mittig angeordnete Befestigungsmittel (14) am Grundkörper (12) befestigt ist und durch keine weiteren Befestigungsmittel mit dem Grundkörper (12) verbunden ist,
wobei der Deckel (13) derart ausgeführt ist, dass er im Falle eines im Innenraum des Gehäuses (11) auftretenden Überdrucks, insbesondere im Falle eines plötzlich auftretenden Überdrucks, allseitig von den Kanten der Seitenwände abhebt und sich plastisch verformt, so dass ein Druckabbau nach allen Seiten ermöglicht wird,
wobei der Deckel (13) einen duktilen Werkstoff aufweist, insbesondere eine Aluminium-Magnesium-Legierung oder ein Tiefziehstahlblech, so dass der Deckel (13) durch eine plastische Verformung Energie aufnehmen kann.

2. Gehäuse (11) nach Anspruch 1 , wobei der Grundkörper (12) eine Rückwand und Seitenwände aufweist und der Deckel (13) eine im Wesentlichen in einer Ebene verlaufende Dichtungsfläche aufweist, mit der der Deckel (13) auf Kanten der Seitenwände des Grundkörpers (12) aufliegt.

3. Gehäuse (11) nach Anspruch 2, wobei zwischen den Kanten der Seitenwände des Grundkörpers (12) und dem Deckel (13) eine umlaufende Dichtung (16) angeordnet ist, auf die durch das Befestigungsmittel (14) über den Deckel (13) eine Druckkraft ausgeübt wird, so dass das Gehäuse (11) derart dicht verschließbar ist, dass eine Schutzart des Innenraums des Gehäuses (11) von mindestens IP44, bevorzugt von mindestens IP65, und/oder Nema Type 4X gewährleistet ist.

4. Gehäuse (11) nach Anspruch 2 oder 3, wobei der Grundkörper (12) eine Traverse (15) aufweist, die an gegenüberliegenden Punkten der Seitenwände des Grundkörpers (12) befestigt ist, wobei mittels des Befestigungsmittels (14) eine lösbare Verbindung zwischen dem Deckel (13) und der Traverse (15) herstellbar ist.

5. Gehäuse (11) nach Anspruch 4, wobei der Grundkörper (12) vier Seitenwände aufweist, die im Wesentlichen senkrecht zueinander angeordnet sind, wobei die Traverse (15) diagonal zwischen zwei gegenüberliegenden Ecken der Seitenwände angeordnet ist.

6. Gehäuse (11) nach einem der Ansprüche 2 bis 3, wobei der Grundkörper (12) einen Dom (19) aufweist, der sich von der Rückwand des Gehäuses (11) bis zur geometrischen Mitte des Deckels (13) erstreckt, wobei mittels des Befestigungsmittels (14) eine lösbare Verbindung zwischen dem Deckel (13) und dem Dom (19) herstellbar ist.

7. Gehäuse (11) nach einem der Ansprüche 4 bis 6, wobei das Befestigungsmittel (14) schraubbar ist und insbesondere eine Schraube oder eine Mutter umfasst, wobei der Schraubenkopf oder die Mutter auf der Außenseite des Deckels (13) angeordnet ist, wobei die Traverse (15) oder der Dom (19) ein Gegengewinde für die Schraube oder eine nach außen gerichtete Gewindestange für die Mutter aufweist.

8. Gehäuse (11) nach Anspruch 7, wobei zwischen dem Schraubenkopf oder der Mutter und dem Deckel (13) eine Versteifungsplatte (17) kraft- und/oder stoffschlüssig angeordnet ist, wobei die Versteifungsplatte (17) bevorzugt einen Durchmesser zwischen dem doppelten Durchmesser des Schraubenkopfes oder der Mutter und dem halben Durchmesser des Deckels (13) aufweist.

9. Gehäuse (11) nach einem der vorangehenden Ansprüche, wobei die Komponenten im Innenraum des Gehäuses (11) leistungselektronische Komponenten umfassen, insbesondere Schalter, Kapazitäten und/oder Induktivitäten, die für die Umwandlung der elektrischen Leistung innerhalb des Gerätes (10) vorgesehen sind.

10. Gehäuse (11) nach einem der vorangehenden Ansprüche, wobei der Rand des Deckels (13) eine umlaufende Abkantung aufweist, so dass der Rand des Deckels (13) im Wesentlichen parallel zu den Seitenwänden des Grundkörpers (12) ausgerichtet ist.

11. Gehäuse (11) nach einem der vorangehenden Ansprüche, wobei das elektrische Gerät (10) einen Leistungswandler umfasst, der insbesondere als Gleichrichter, als Wechselrichter und/oder als DC/DC-Wandler ausgeführt ist und eine elektrische Nennleistung von mindestens ein Kilowatt, bevorzugt von mindestens zehn Kilowatt aufweist.

12. Elektrisches Gerät (10) mit einem Gehäuse (11) gemäß einem der vorangehenden Ansprüche, wobei das Gerät (10) einen ersten Anschluss und einen zweiten Anschluss umfasst, wobei der erste Anschluss zur Verbindung mit einer ersten Energiequelle oder einer ersten Energiesenke, insbesondere mit einem Generator oder einer Batterie, und der zweite Anschluss zur Verbindung mit einer zweiten Energiequelle oder einer zweiten Energiesenke, insbesondere mit einem Energieversorgungsnetzwerk, eingerichtet ist..

13. Elektrisches Gerät (10) nach Anspruch 12, wobei das Gerät (10) ein Photovoltaik-Wechselrichter oder ein bidirektionaler Batterie-Wechselrichter zum Anschluss an ein Wechselspannungsnetz ist.

14. Elektrisches Gerät (10) nach Anspruch 12, wobei das Gerät (10) ein DC/DC-Wandler zur Verbindung eines Photovoltaik-Generators oder einer Batterie mit einem Wechselrichter oder einer Last ist, wobei die Last ein Gleichspannungsnetz umfassen kann.

15. Elektrisches Gerät (10) nach einem der Ansprüche 12 bis 14, wobei das Gerät (10) eine elektrische Nennleistung von mindestens ein Kilowatt, bevorzugt von mindestens zehn Kilowatt aufweist.

## Claims

1. Housing (11) of an electrical device (10) for converting electrical power, wherein the housing (11) has a base body (12) and a cover (13), wherein the cover (13) closes the base body (12) so that a sealed interior space is formed, wherein electrical and electronic components of the electrical appliance (10) are arranged in the interior of the housing (11), wherein the cover (13) is connected to the base body (12) via a detachable fastening means (14), wherein the fastening means (14) is arranged in the geometric centre of the cover (13), **characterised in that**
the cover (13) is fastened to the main body (12) exclusively by the centrally arranged fastening means (14) and is not connected to the main body (12) by any other fastening means,
wherein the cover (13) is designed in such a way that, in the event of excess pressure occurring in the interior of the housing (11), in particular in the event of sudden excess pressure, it lifts off on all sides from the edges of the side walls and deforms plastically, so that pressure can be relieved on all sides,
wherein the cover (13) comprises a ductile material, in particular an aluminium-magnesium alloy or a deep-drawn steel sheet, so that the cover (13) can absorb energy by plastic deformation.

2. Housing (11) according to claim 1 , wherein the base body (12) has a rear wall and side walls and the cover (13) has a sealing surface running essentially in one plane, with which the cover (13) rests on edges of the side walls of the main body (12).

3. Housing (11) according to claim 2, wherein a circumferential seal (16) is arranged between the edges of the side walls of the main body (12) and the cover (13), on which a compressive force is exerted by the fastening means (14) via the cover (13), so that the housing (11) can be sealed in such a way that a degree of protection of the interior of the housing (11) of at least IP44, preferably of at least IP65, and/or Nema Type 4X is ensured.

4. Housing (11) according to claim 2 or 3, wherein the base body (12) has a cross-member (15) which is fastened to opposite points of the side walls of the main body (12), wherein a detachable connection between the cover (13) and the cross-member (15) can be produced by means of the fastening means (14).

5. Housing (11) according to claim 4, wherein the main body (12) has four side walls which are arranged substantially perpendicular to one another, wherein the cross-member (15) is arranged diagonally between two opposite corners of the side walls.

6. Housing (11) according to one of claims 2 to 3, wherein the main body (12) has a dome (19) which extends from the rear wall of the housing (11) to the geometric centre of the cover (13), wherein a detachable connection can be produced between the cover (13) and the dome (19) by means of the fastening means (14).

7. Housing (11) according to one of claims 4 to 6, wherein the fastening means (14) is screwable and in particular comprises a screw or a nut, wherein the screw head or the nut is arranged on the outside of the cover (13), wherein the crosspiece (15) or the dome (19) has a mating thread for the screw or an outwardly directed threaded rod for the nut.

8. Housing (11) according to claim 7, wherein a stiffening plate (17) is arranged between the screw head or the nut and the cover (13) in a force-locking and/or material-locking manner, wherein the stiffening plate (17) preferably has a diameter between twice the diameter of the screw head or the nut and half the diameter of the cover (13).

9. Housing (11) according to one of the preceding claims, wherein the components in the interior of the housing (11) comprise power electronic components, in particular switches, capacitors and/or inductors, which are provided for the conversion of the electrical power within the device (10).

10. Housing (11) according to one of the preceding claims, wherein the edge of the cover (13) has a circumferential bevelled edge, so that the edge of the cover (13) is aligned substantially parallel to the side walls of the main body (12)

11. Housing (11) according to one of the preceding claims, wherein the electrical device (10) comprises a power converter, which is designed in particular as a rectifier, as an inverter and/or as a DC/DC converter and has a rated electrical power of at least one kilowatt, preferably of at least ten kilowatts.

12. Electrical device (10) with a housing (11) according to one of the preceding claims, wherein the device (10) comprises a first connection and a second connection, wherein the first connection is set up for connection to a first energy source or a first energy sink, in particular to a generator or a battery, and the second connection is set up for connection to a second energy source or a second energy sink, in particular to an energy supply network.

13. Electrical device (10) according to claim 12, wherein the device (10) is a photovoltaic inverter or a bidirectional battery inverter for connection to an alternating voltage network.

14. Electrical device (10) according to claim 12, wherein the device (10) is a DC/DC converter for connecting a photovoltaic generator or a battery to an inverter or a load, wherein the load may comprise a DC grid.

15. Electrical device (10) according to any one of claims 12 to 14, wherein the device (10) has a rated electrical power of at least one kilowatt, preferably at least ten kilowatts.

## Revendications

1. Boîtier (11) d'un appareil électrique (10) pour la conversion de puissance électrique, le boîtier (11) présentant un corps de base (12) et un couvercle (13), le couvercle (13) fermant le corps de base (12) de manière à former un espace intérieur fermé, des composants électriques et électroniques de l'appareil électrique (10) étant disposés dans l'espace intérieur du boîtier (11), le couvercle (13) étant relié au corps de base (12) par un moyen de fixation amovible (14), le moyen de fixation (14) étant disposé au centre géométrique du couvercle (13), **caractérisé en ce que**
le couvercle (13) est fixé au corps de base (12) exclusivement par le moyen de fixation (14) disposé au centre et n'est relié au corps de base (12) par aucun autre moyen de fixation,
le couvercle (13) étant réalisé de telle sorte que, dans le cas d'une surpression se produisant à l'intérieur du boîtier (11), en particulier dans le cas d'une surpression soudaine, il se soulève de tous les côtés des bords des parois latérales et se déforme plastiquement, de manière à permettre une réduction de la pression vers tous les côtés,
le couvercle (13) présentant un matériau ductile, notamment un alliage aluminium-magnésium ou une tôle d'acier emboutie, de sorte que le couvercle (13) peut absorber de l'énergie par une déformation plastique.

2. Boîtier (11) selon la revendication 1 , dans lequel le corps de base (12) présente une paroi arrière et des parois latérales et le couvercle (13) présente une surface d'étanchéité s'étendant sensiblement dans un plan, par laquelle le couvercle (13) repose sur des arêtes des parois latérales du corps de base (12).

3. Boîtier (11) selon la revendication 2, dans lequel entre les bords des parois latérales du corps de base (12) et le couvercle (13) est disposé un joint d'étanchéité (16) périphérique sur lequel est exercée une force de pression par le moyen de fixation (14) via le couvercle (13), de sorte que le boîtier (11) peut être fermé de manière étanche de telle sorte qu'un type de protection de l'intérieur du boîtier (11) d'au moins IP44, de préférence d'au moins IP65, et/ou Nema Type 4X est garanti.

4. Boîtier (11) selon la revendication 2 ou 3, dans lequel le corps de base (12) présente une traverse (15) qui est fixée à des points opposés des parois latérales du corps de base (12), une liaison amovible entre le couvercle (13) et la traverse (15) pouvant être réalisée à l'aide du moyen de fixation (14).

5. Boîtier (11) selon la revendication 4, dans lequel le corps de base (12) présente quatre parois latérales qui sont disposées sensiblement perpendiculairement les unes aux autres, la traverse (15) étant disposée en diagonale entre deux coins opposés des parois latérales.

6. Boîtier (11) selon l'une des revendications 2 à 3, dans lequel le corps de base (12) présente un dôme (19) qui s'étend depuis la paroi arrière du boîtier (11) jusqu'au centre géométrique du couvercle (13), une liaison amovible entre le couvercle (13) et le dôme (19) pouvant être réalisée au moyen du moyen de fixation (14).

7. Boîtier (11) selon l'une des revendications 4 à 6, dans lequel le moyen de fixation (14) est vissable et comprend notamment une vis ou un écrou, la tête de vis ou l'écrou étant disposé sur la face extérieure du couvercle (13), la traverse (15) ou le dôme (19) présentant un contre-filetage pour la vis ou une tige filetée orientée vers l'extérieur pour l'écrou.

8. Boîtier (11) selon la revendication 7, dans lequel une plaque de renforcement (17) est disposée entre la tête de vis ou l'écrou et le couvercle (13) par adhérence et/ou par liaison de matière, la plaque de renforcement (17) présentant de préférence un diamètre compris entre le double du diamètre de la tête de vis ou de l'écrou et la moitié du diamètre du couvercle (13).

9. Boîtier (11) selon l'une quelconque des revendications précédentes, dans lequel les composants à l'intérieur du boîtier (11) comprennent des composants d'électronique de puissance, en particulier des commutateurs, des capacités et/ou des inductances, qui sont prévus pour la conversion de la puissance électrique à l'intérieur de l'appareil (10).

10. Boîtier (11) selon l'une des revendications précédentes, dans lequel le bord du couvercle (13) présente un pliage périphérique, de sorte que le bord du couvercle (13) est orienté sensiblement parallèlement aux parois latérales du corps de base (12).

11. Boîtier (11) selon l'une des revendications précédentes, dans lequel l'appareil électrique (10) comprend un convertisseur de puissance, qui est réalisé en particulier sous forme de redresseur, d'onduleur et/ou de convertisseur DC/DC et qui présente une puissance électrique nominale d'au moins un kilowatt, de préférence d'au moins dix kilowatts.

12. Appareil électrique (10) comprenant un boîtier (11) selon l'une quelconque des revendications précédentes, l'appareil (10) comprenant une première borne et une deuxième borne, la première borne étant agencée pour être connectée à une première source d'énergie ou à un premier puits d'énergie, notamment à un générateur ou à une batterie, et la deuxième borne étant agencée pour être connectée à une deuxième source d'énergie ou à un deuxième puits d'énergie, notamment à un réseau d'alimentation en énergie.

13. Appareil électrique (10) selon la revendication 12, dans lequel l'appareil (10) est un onduleur photovoltaïque ou un onduleur de batterie bidirectionnel destiné à être connecté à un réseau de tension alternative.

14. Appareil électrique (10) selon la revendication 12, dans lequel l'appareil (10) est un convertisseur DC/DC pour connecter un générateur photovoltaïque ou une batterie à un onduleur ou à une charge, la charge pouvant comprendre un réseau de tension continue.

15. Appareil électrique (10) selon l'une des revendications 12 à 14, dans lequel l'appareil (10) présente une puissance électrique nominale d'au moins un kilowatt, de préférence d'au moins dix kilowatts.
